# EUROPÄISCHE PATENTANMELDUNG

(11) **EP 1 137 055 A1**
(43) Veröffentlichungstag der Anmeldung: **26.09.2001**
(21) Anmeldenummer: 00106460.9
(22) Anmeldetag: 24.03.2000
(51) Int. Cl.: H01L 21/20, H01L 21/205

(54) **Verfahren zur Herstellung einer Hochfrequenz-Halbleiterstruktur und Hochfrequenz-Halbleiterstruktur**

(71) Anmelder: Infineon Technologies AG, 81669 München (DE)
(72) Erfinder: Losehand, Reinhard, 80637 München (DE); Werthmann, Hubert, 81247 München (DE)
(74) Vertreter: Epping, Wilhelm, Dipl.-Ing.

(57) **Zusammenfassung**

Zur Herstellung von Bauelementen einer Halbleiterstruktur wird auf eine Wanne (3) in einem Substrat (2) eine Pufferschicht (4) epitaktisch aufgewachsen und anschließend im Bereich außerhalb der Wannen (3) entfernt. Durch diese Maßnahme werden Randverluste aufgrund der leitfähigen, selbstdotierten Schicht entlang der Grenzfläche des Substrats (2) zu einer nachfolgenden Epitaxieschicht (5) vermindert. Die Bauelemente eignen sich insbesondere für Hochfrequenzanwendungen.

## Beschreibung

Die Erfindung betrifft ein Verfahren zur Herstellung einer Hochfrequenz-Halbleiterstruktur mit den Verfahrensschritten:
- Bereitstellen eines Substrats;
- Ausbilden einer Wanne auf einer Seite des Substrats; und
- epitaktisches Aufwachsen einer Pufferschicht oberhalb der Wanne.

Die Erfindung betrifft ferner eine Halbleiterstruktur mit einer in einem Substrat ausgebildeten Wanne, über der sich eine Pufferschicht aus Substratmaterial befindet.

Aus der DE 197 37 360 C1 ist eine Hochfrequenz-Schottky-Diode und ein Verfahren zu deren Herstellung bekannt. Zur Herstellung der bekannten Hochfrequenz-Schottky-Diode wird in p-dotiertem Substrat eine n-dotierte Wanne ausgebildet. In einem nächsten Schritt wird auf die Wanne eine n-dotierte Epitaxieschicht aufgebracht. Nachfolgend wird mittels Fototechnik und Plasmaätzen die Epitaxieschicht derart strukturiert, daß nur noch ein zentraler Bereich der Wanne von der Epitaxieschicht bedeckt ist. Dadurch entsteht eine Erhöhung auf der Wanne, die von einer ringförmigen Vertiefung umgeben ist. In nachfolgenden Verfahrensschritten wird unter anderem auf der Erhöhung eine Metallschicht zur Ausbildung eines Schottky-Kontakt abgeschieden.

Die Wanne ist mit Arsen dotiert und weist einen Dotierstoffgehalt von 5 bis 6 x 1019 cm⁻³ auf. Außerdem zeichnet sich das Substrat durch einen spezifischen Widerstand von mehr als 3 kΩcm aus. Dadurch werden die Verluste der Hochfrequenz-Schottky-Diode wirksam begrenzt.

Zur Herstellung handlicher Mobilfunkgeräte sollen möglichst alle Bauteile der Schaltungsanordnung monolithisch integriert werden. Die vorgesehenen Betriebsfrequenzen liegen dabei um 1 GHz und darüber. In diesem Frequenzbereich ergeben sich hohe Anforderungen an die Güte der verwendeten passiven und aktiven Bauelemente. Diskrete Schaltungen weisen in diesem Frequenzbereich im allgemeinen bei Mittelung über die verschiedenen aktiven und passiven Bauelemente eine Durchschnittsgüte von 100 auf. So führt zum Beispiel die Kombination eines Resonators hoher Güte (Q = 200) mit Dioden mittlerer Güte (Q = 50) noch zu einer mittleren Güte im Bereich von 100. Da zu erwarten ist, daß bei der Integration der aktiven und passiven Bauelemente Spitzengüten nicht zu erzielen sind, muß für die einzelnen aktiven und passiven Bauelemente eine mittlere Güte von etwa 100 gefordert werden. Insbesondere muß auch auf die Güte der Transistoren geachtet werden. Zwar wird ein etwa vorhandener Verlust durch die Transistorverstärkung kompensiert, aber mit der zunehmenden Verstärkung durch Transistoren nimmt auch das Rauschen in der Schaltung zu. Deshalb sind auch die Transistorverluste möglichst niedrig zu halten.

Ausgehend von diesem Stand der Technik liegt der Erfindung die Aufgabe zugrunde, ein Verfahren zur Herstellung möglichst verlustfreier Halbleiterstrukturen zu schaffen.

Weiter ist es Aufgabe der Erfindung, eine Halbleiterstruktur mit geringen Verlusten und damit hoher Güte zu schaffen.

Diese Aufgaben werden jeweils durch ein Verfahren mit den Merkmalen des Anspruchs 1 und eine Halbleiterstruktur mit den Merkmalen des Anspruchs 9 gelöst.

Im Verfahren nach Anspruch 1 und bei der Halbleiterstruktur nach Anspruch 9 ist jeweils eine Pufferschicht vorgesehen, die die im Substrat ausgebildete Wanne abdeckt. Zur Herstellung der epitaktisch aufgebrachten Pufferschicht ist undotiertes Material vorgesehen. Aufgrund der Selbstdotierung (Autodoping) enthält die Pufferschicht jedoch Dotieratome, die während des epitaktischen Aufwachsens der Pufferschicht aus der Wanne abdampfen und in die Pufferschicht eingebaut werden. Dadurch entsteht eine leitfähige Schicht. Da über die leitfähige Pufferschicht Leckströme fließen können, muß derjenige Teil der Pufferschicht, der nicht auf der Wanne aufliegt, entfernt werden. Durch das Entfernen der unmittelbar auf dem Substrat aufliegende Schicht wird der Ableitwiderstand wirksam erhöht. Denn aufgrund des geringen Dotierstoffgehalts an der Oberfläche der Pufferschicht findet in nachfolgenden Epitaxievorgängen kaum Selbstdotierung statt. Demnach weisen die nachfolgenden Epitaxieschichten von sich aus eine geringe Leitfähigkeit auf. Um die Ableitung an den Rändern der Wanne zu begrenzen, genügt es daher, zunächst eine Pufferschicht epitaktisch aufzuwachsen, bis keine Selbstdotierung mehr stattfindet und anschließend die Pufferschicht im Bereich außerhalb der Wannen entweder in der Dicke zu reduzieren oder vollständig zu entfernen.

Bei einer Ausführungsform des Verfahrens gemäß der Erfindung wird ein hochohmiges Substrat verwendet, in dem eine möglichst niederohmige Wanne ausgebildet wird.

Dadurch gelingt es zum einen, den Innenwiderstand der Wanne zu verringern. Zum anderen wird auch die Kapazität der Grenzfläche zwischen Wanne und Substrat herabgesetzt und der Ableitwiderstand des Substrats erhöht. Durch die genannten Maßnahmen läßt sich die Verlustleistung von Bauelementen, die die Wanne als eine ihrer Elektroden verwenden, verringern.

Aber auch für Bauelemente ohne im Substrat ausgebildete Wanne ist das Entfernen oder Ausdünnen der Pufferschicht von Vorteil. Denn die fehlende Pufferschicht führt zu einem hochohmigen Unterbau für diejenigen passiven Bauelemente, die ohne Wanne im Substrat auskommen. Dadurch ergeben sich hohe Parallelwiderstände, die geringe Verluste zur Folge haben.

Nachfolgend wird die Erfindung im einzelnen anhand der beigefügten Zeichnung erläutert. Es zeigen:
- Figur 1: einen Querschnitt durch einen Varaktor;
- Figur 2: ein Ersatzschaltbild für den Varaktor aus Figur 1;
- Figur 3: einen Querschnitt durch eine PIN-Diode;
- Figur 4: einen Querschnitt durch einen bipolaren Transistor;
- Figur 5: einen Querschnitt durch bipolare Transistoren hoher Packungsdichte;
- Figur 6: einen Querschnitt durch einen Kondensator mit einer im Substrat ausgebildeten Wanne;
- Figur 7: einen Querschnitt durch einen Widerstand;
- Figur 8: einen Querschnitt durch eine Spule; und
- Figur 9 bis 20: Querschnitte durch eine Halbleiterstruktur während der Herstellung.

In der nachfolgenden Beschreibung der in den Figuren dargestellten Ausführungsbeispiele bezeichnen gleiche Bezugszeichen jeweils einander entsprechende Teile.

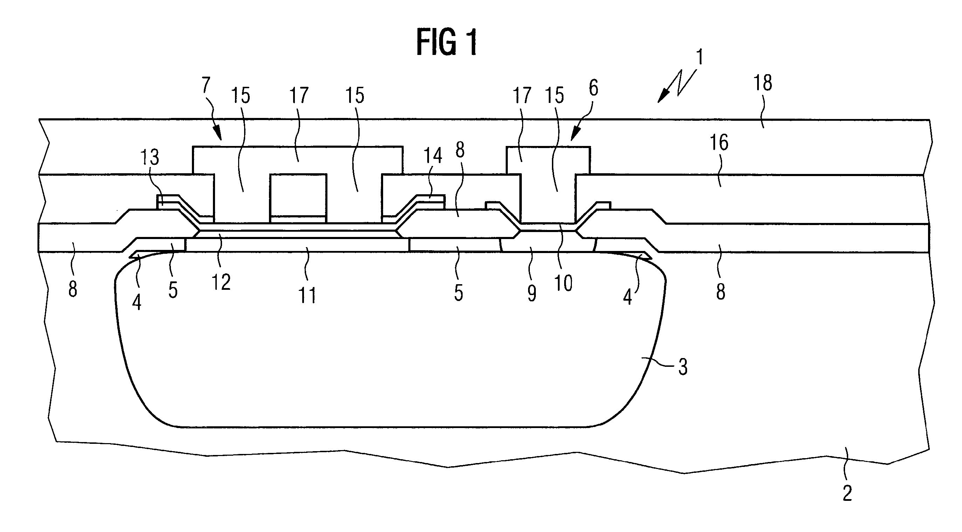

In Figur 1 ist ein Varaktor 1 dargestellt. Der Varaktor 1 weist ein hochohmiges Substrat 2 mit einem spezifischen Widerstand größer 1 kΩcm auf. In dem Substrat 2 ist eine niederohmige Wanne 3 (Buried Layer) ausgebildet. Die Wanne 3 weist vorzugsweise einen Widerstand von weniger 5 Ω/Square auf. Um diese Werte zu erzielen, sollte die Dotierung des Substrats 2 unterhalb von 8 x 10¹² cm⁻³ und die Dotierung der Wanne oberhalb von 5 x 10¹⁹ cm⁻³ liegen. Außerdem sollte die Wanne 3 eine Tiefe von mehr als 10 µm aufweisen. Dadurch ergeben sich für die Wanne 3 Schichtwiderstände von nur 3 Ω.

Oberhalb der Wanne 3 ist eine Pufferschicht 4 ausgebildet, die außerhalb der Wanne 3 zurückgeätzt worden ist. Auf der Pufferschicht 4 ist eine Epitaxieschicht 5 angeordnet, die bis auf einen Kollektorbereich 6 und einem Basisbereich 7 von einer Isolierschicht abgedeckt ist. Im Kollektorbereich 6 ist in der Epitaxieschicht 5 ein Kontaktbereich 9 ausgebildet, an den sich eine Kollektorkontaktschicht 10 anschließt. Im Basisbereich 7 ist in der Epitaxieschicht 5 eine Profilimplantation 11 eingebracht, deren Art der Dotierung mit der Art der Dotierung der Wanne 3 übereinstimmt. Außerdem ist in der Epitaxieschicht 5 im Basisbereich 7 eine Basisschicht 12 vorhanden, die die entgegengesetzte Dotierung zur Profilimplantation 11 und der Wanne 3 aufweist. Der Basisschicht 12 ist eine Basiskontaktschicht 13 nachgeordnet, die mit ihren Rändern auf der Isolierschicht 8 aufliegt. Oberhalb der Basiskontaktschicht 13 befindet sich eine Kontaktisolierschicht 5, die von Anschlußkontakten 15 unterbrochen ist. Ebenso ist in dem Kollektorbereich 6 ein Anschlußkontakt 15 vorgesehen, der an der Kollektorkontaktschicht 10 anliegt. Die Anschlußkontakte 15 führen durch eine Abdeckschicht 16 hindurch zu Leiterbahnen 17, die in ein Zwischenlagendielektrikum 18 eingebettet sind.

Als Substrat 2 wird zum Beispiel p-leitendes Silizium mit der Kristallorientierung <100> verwendet. Wie bereits erwähnt, soll die Dotierung des Siliziums kleiner 8 x 1012 cm⁻³ betragen. Die Wanne 3 wird beispielsweise durch Dotierung des Substrats 2 mit Arsen mit einer Konzentration von mehr als 5 x 1019 cm⁻³ gebildet. Die Pufferschicht 4, die Epitaxieschicht 5 und die Basisschicht 12 sind in diesem Fall ebenfalls aus Silizium hergestellt, wobei die Basisschicht 12 mit Hilfe von Bor n-dotiert ist. Die Basiskontaktschicht 13 und die Kollektorkontaktschicht 10 sind bei dem in Figur 1 dargestellten Ausführungsbeispiel zweckmäßigerweise aus n-dotiertem Polysilizium gefertigt. Bei der Isolierschicht 8 und der Kontaktisolierschicht 14 handelt es sich um Oxidschichten, beispielsweise aus SiO₂. Die Abdeckschicht 16 kann aus borhaltigem Phosphorglas (BPSG) gefertigt sein. Beim Zwischenlagendielektrikum 18 handelt es sich schließlich um eine IMOX-Schicht. Die Anschlußkontakte 15 können aus einer Wolframlegierung gefertigt sein. Für die Leiterbahnen 17 ist AlSiCu vorgesehen.

Die Konzentration der Dotieratome in der Basisschicht 12 liegt bei 10²⁰ cm⁻³. Daran schließt sich für die Profilimplantation 11 mit einer von 10¹⁸ cm⁻³ auf 1016 cm⁻³ abfallenden Konzentration an Dotieratomen an. Die Basiskontaktschicht 13 und die Kollektorkontaktschicht 10 sind jeweils mit einer Konzentration von 10²¹ cm⁻³ dotiert.

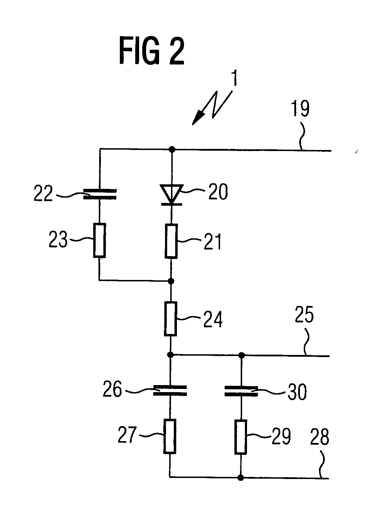

Figur 2 zeigt ein Ersatzschaltbild für die Abstimmdiode oder den Varaktor 1 aus Figur 1. Das Ersatzschaltbild weist einen Basisanschluß 19 auf, der dem Anschluß 15 im Basisbereich 7 entspricht. Der Basisanschluß 19 führt zu einer idealen Diode 20, die in Reihe zu einem ohmschen Widerstand 21 geschaltet ist. Parallel zu der idealen Diode 20 ist eine Kapazität 22 in Reihe zu einem weiteren ohmschen Widerstand 23 geschaltet. Die Widerstände 21 und 23 veranschaulichen die Verluste in den Anschlußkontakten 15, der Basiskontaktschicht 13, der Basisschicht 12 und der Profilimplantation 11. Einer weiterer serieller Widerstand 24 führt zu einem Kollektoranschluß 20, der dem Anschlußkontakt 15 im Kollektorkontaktbereich 9 entspricht. Der Widerstand 24 veranschaulicht die Verluste in der Wanne 3.

Durch die Kapazität 22 wird die Kapazität des pn-Übergangs entlang der Grenzfläche zwischen der Basisschicht 12 und der Profilimplantation 11 berücksichtigt. Daneben besteht ein weiterer pn-Übergang zwischen der Wanne 3 und dem Substrat 2. Die Kapazität dieses pn-Übergangs ist im Ersatzschaltbild in Figur 2 durch eine Grenzflächenkapazität 26 berücksichtigt. Die Ableitung durch das Substrat 2 zu einer auf Masse gelegten Legierinsel ist in Figur 2 durch einen Substratwiderstand 27 veranschaulicht, der zu einem Masseanschluß 28 führt.

Falls im Bereich der Epitaxieschicht 5 eine Channelstopimplantation eingebracht worden ist, ist zwischen Substrat 2 und Channelstopimplantation eine Leitschicht vorhanden. Außerdem bildet die selbstdotierte Pufferschicht 4 eine leitfähige Schicht aus. Der Widerstand der beiden leitfähigen Schichten ist in Figur 2 in einem Randschichtenwiderstand 29 zusammengefaßt. Die Tatsache, daß beide Leitschichten über eine Koppelkapazität zusammenwirken, ist in Figur 2 durch eine Randschichtkapazität 30 berücksichtigt.

Um die Verluste des Varaktors 1 möglichst klein zu halten, muß insbesondere der Wannenwiderstand 24 möglichst gering gehalten werden. Dies wird durch die hohe Dotierung der Wanne 3 erreicht.

Darüber hinaus ist erforderlich, die in den leitfähigen Randschichten stehenden Verluste möglichst zu begrenzen. Bei dem in Figur 1 dargestellten Ausführungsbeispiel ist daher keine Channelstopimplantation in der Epitaxieschicht 5 vorgesehen. Die Channelstopimplantation kann entfallen, da der parasitäre Bipolartransistor zwischen den Wannen 3 zu langsam ist, um bei den relevanten Hochfrequenzen technisch eine Rolle zu spielen. Wichtig ist nur, daß dieser parasitäre Bipolartransistor keinen Zustand annehmen kann, der zu Problemen führt. Modellrechnungen haben ergeben, daß sich bei einem lichten Abstand von 20 µm das zwischen den Wannen 3 gelegene Basisgebiet des parasitären Bipolartransistors wie ein hochohmiges Widerstandsgebiet verhält, das bei den relevanten Hochfrequenzen kapazitives Verhalten zeigt.

Außerdem ist die leitfähige, selbstdotierte Pufferschicht 4 außerhalb des Bereichs der Wanne 3 vor dem Aufwachsen der Epitaxieschicht entfernt worden.

Diese Maßnahmen gewährleisten einen geringen Randschichtwiderstand 29 und eine verschwindend kleine Randschichtkapazität 30, so daß die Randschichtverluste zu vernachlässigen sind.

Bei einem abgewandelten, nicht dargestellten Ausführungsbeispiel des Varaktors 1 wird die Pufferschicht 4 zusammen mit der Epitaxieschicht 5 in einem Epitaxievorgang aufgebracht und anschließend außerhalb des Bereichs der Wanne 3 bis auf das Substrat 2 zurückgeätzt. Dies ist jedoch nur dann möglich, wenn die dabei entstehende Stufe von etwa 1 µm in der Folgeprozessen toleriert werden kann.

Wenn jedoch auf eine möglichst flache Struktur Wert gelegt wird, ist es von Vorteil zunächst die Pufferschicht 4 mit einer Dicke von 0,15 µm aufzuwachsen und anschließend außerhalb des Bereichs der Wanne 3 um 0,2 um zurückzuätzen. Auf diese Weise wird die selbstdotierte Pufferschicht mit großer Sicherheit vollständig entfernt, so daß keine leitfähige Schicht entlang der Grenzfläche zwischen Substrat und darüberliegender Isolierschicht entsteht.

Auch bei anderen Arten von Bauelementen einer Halbleiterstruktur können die Verluste durch Vorsehen einer Pufferschicht 4 und nachfolgendes Zurückätzen der Pufferschicht 4 außerhalb des Bereichs der Wannen 3 begrenzt werden.

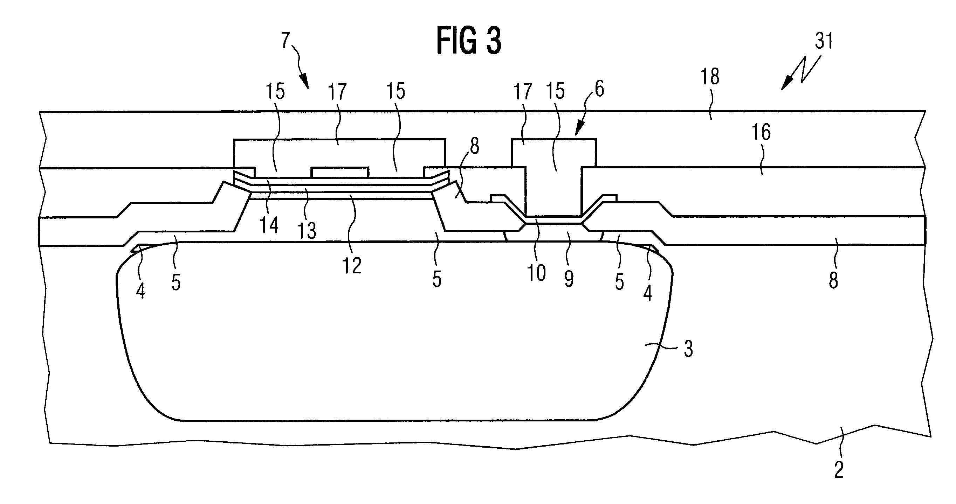

In Figur 3 ist beispielsweise eine PIN-Diode 31 dargestellt. Bei dieser PIN-Diode 31 wird das intrinsische Gebiet von einer Epitaxieschicht großer Dicke gebildet, die im Basisbereich 7 in Mesaform geätzt ist.

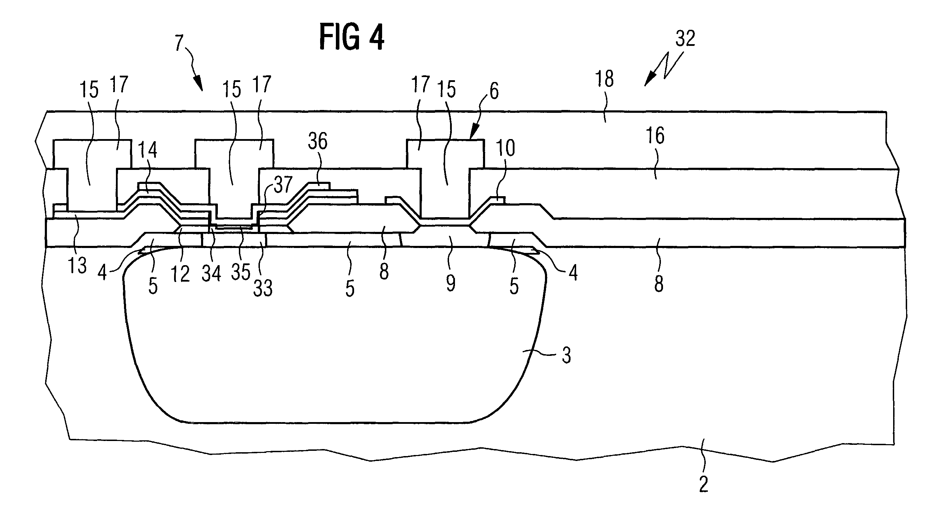

In Figur 4 ist weiterhin ein bipolarer Transistor 32 mit geringen Kollektorverlusten im Querschnitt dargestellt. Der bipolare Transistor 32 verfügt ebenfalls über die Pufferschicht 4, die außerhalb der Wanne 3 entfernt ist. Im Basisbereich 7 ist in der über der Pufferschicht 4 liegenden Epitaxieschicht 5 eine Kollektortiefimplantation 33 eingebracht. An die Kollektortiefimplantation 33 schließt sich die Basisschicht 12 mit einer Basiszone 34 an. Die Basiszone 34 umschließt eine Emitterzone 35, an der eine Emitterkontaktschicht 36 anliegt. Zur Seite hin ist die Emitterkontaktschicht 36 von Abstandsstücken 37 begrenzt. Die Basiskontaktschicht 13 sowie die Emitterkontaktschicht 36 sind über Anschlußkontakte 15 zu Leiterbahnen 17 geführt.

Wie bereits im Zusammenhang mit dem in Figur 1 dargestellten Varaktor ausgeführt, werden auch bei der PIN-Diode 31 und dem bipolaren Transistor 32 die Kollektorverluste durch das Unterbrechen der Pufferschicht 4 niedrig gehalten.

Dazu ist jedoch auch eine hinreichend lichte Weite zwischen den Wannen 3 der Bauelemente erforderlich, da ansonsten der parasitäre bipolare Transistor zwischen den Wannen 3 zu Verlusten führt.

Ein Ausführungsbeispiel, mit dem hohe Packungsdichten möglich sind, ist in Figur 3 am Beispiel eines abgewandelten bipolaren Transistors 38 und benachbarten Wanne 3 dargestellt. In diesem Ausführungsbeispiel sind die Wannen 3 von Grenzgebieten 39 mit einer erhöhten entgegengesetzten Dotierung umgeben. Beispielsweise ist das Substrat 2 p-dotiert und die n-dotierten Wannen 3 von einem p-dotierten Grenzgebiet 39 erhöhter Konzentration umgeben. Dadurch wird die Grenzflächenkapazität 26 erniedrigt. Außerdem ist eine Packungsdichte wie bei herkömmlichen Bauelementen möglich, denn durch die Grenzgebiete 39 werden die Wannen 3 auf wirksame Weise elektrisch getrennt.

Um die elektrische Trennung der Wannen 3 in jedem Betriebszustand zu gewährleisten, ist ferner ein Trenngebiet 40 vorgesehen, das über einen Anschlußkontakt 15 an eine auf Massepotential liegende Leiterbahn 17 angeschlossen ist. Dadurch ist sichergestellt, daß der parasitäre Bipolartransistor zwischen den Wannen 3 nicht öffnet.

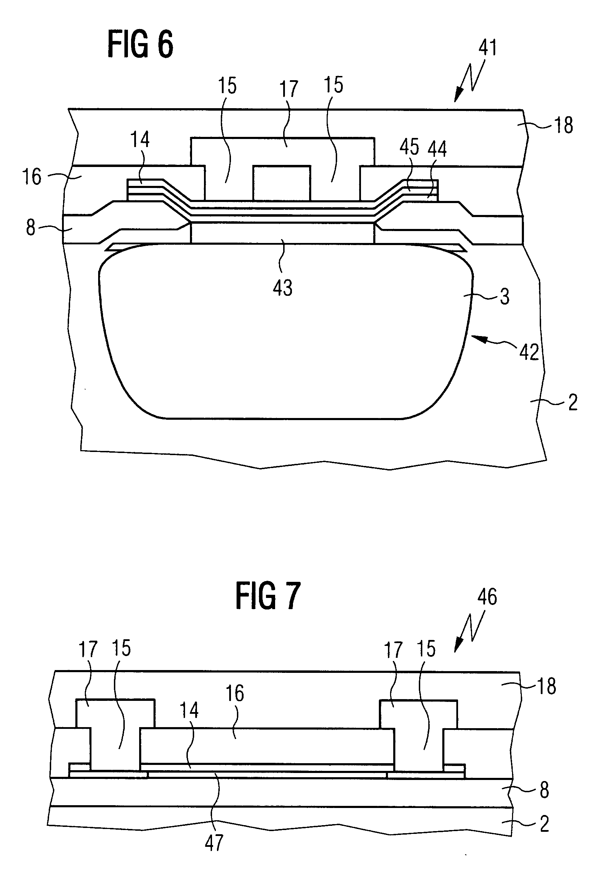

In der Figur 6 ist schließlich ein Kondensator 41 dargestellt, dessen Anode 42 von der Wanne 3 und einer Elektrodenimplantation 43 in der Epitaxieschicht 5 gebildet ist. Der Elektrodenimplantation 43 ist ein Zwischendielektrikum 44 nachgeordnet, auf dem eine Kathode 45 des Kondensators 41 aufgebracht ist.

Auch hier werden Verluste vermieden, indem eine auf den Bereich der Wanne 3 in ihrer Ausdehnung beschränkte Pufferschicht vorgesehen ist.

Das Entfernen der selbstdotierten Pufferschicht 4 außerhalb des Bereichs der Wannen 3 ist auch für passive Bauelemente von Vorteil, die keine Wanne 3 im Substrat 2 benötigen.

In Figur 7 ist beispielsweise ein ohmscher Widerstand 46 dargestellt. Der Widerstand 46 ist von einer Widerstandsschicht 47 auf der Isolierschicht 8 gebildet. Die Widerstandsschicht 47 besteht beispielsweise aus einer Siliziumschicht mit geringer Bor-Dotierung.

Da entlang der Grenzfläche zwischen dem Substrat 2 und der Isolierschicht 8 keine selbstdotierte Pufferschicht 4 vorhanden ist, existieren entlang dieser Grenzfläche auch keine Ladungsträger. Die kapazitive Kopplung der Widerstandsschicht 47 mit dem Substrat 2 führt daher nicht zu parasitären Verlusten.

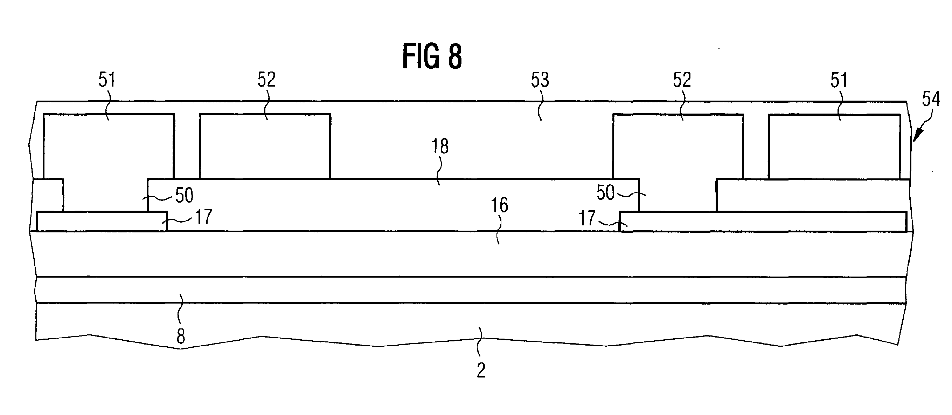

Auch bei der Herstellung von Spulen 48 in der Halbleiterstruktur kann das hochohmige Substrat 2 von Vorteil sein. Figur 8 zeigt eine Ausführungsform einer derartigen Spule 48. In einer ersten Metallebene 49 sind dabei die Leiterbahnen 17 angeordnet, die über Anschlußkontakte 50 durch das Zwischenlagendielektrikum 18 hindurch zu einer ersten Windung 51 und einer zweiten Windung 52 führen. Die erste Windung 51 und die zweite Windung 52 sind in ein Lagendielektrikum 53 eingebettet. Die Ebene, in der sich die erste Windung 51 und die zweite Windung 52 befinden, wird auch als zweite Metallebene 54 bezeichnet.

Es hat sich herausgestellt, daß auf dem hochohmigen Substrat Induktivitäten hoher Güte bis zu Frequenzen von 1 GHz herstellbar sind, wenn die Metallisierungsschichtdicke in der verwendeten zweiten Metallebene 54 auf etwa doppelte Skintiefe, also etwa 4 µm, gehalten werden kann. Induktivitäten mit Güten von über 50 bei einer Frequenz von 0,8 GHz sind mit Spulendurchmessern kleiner 500 µm realisierbar. Noch höhere Güten lassen sich erzielen, wenn Spulen mit größeren Spulendurchmessern verwendet werden. Allerdings nehmen dann die Parallelkapazitäten zu. Denn zum einen steigt die Kapazität zwischen den Windungen und zum anderen wächst die Kapazität zwischen den Windungen und dem Substrat an. Außerdem ergeben sich Verluste durch den Leitungswiderstand der Windungen 51 und 52 und dem Parallelwiderstand des Substrats 2. Dieser Parallelwiderstand beruht auf einer etwa noch vorhandenen Selbstdotierung der Pufferschicht 4, falls die Pufferschicht 4 nicht entfernt ist.

Für die Spulen 48 ist ein hochohmiges Substrat 2 von besonderer Bedeutung, da es nicht möglich ist, Verluste durch ein gut leitendes Substrat zu unterbinden. Insbesondere der spezifische Widerstand von Silizium mit Bestwerten von 3 Ωcm reicht nicht aus, um starke Verluste zu vermeiden.

Es sei angemerkt, daß als Massegegenelektrode zu den Spulen 48 gut leitfähiges Metall verwendet werden muß. Im Falle des hochohmigen Substrats 2 ist dies die Rückseitenmetallisierung des Substrats 2.

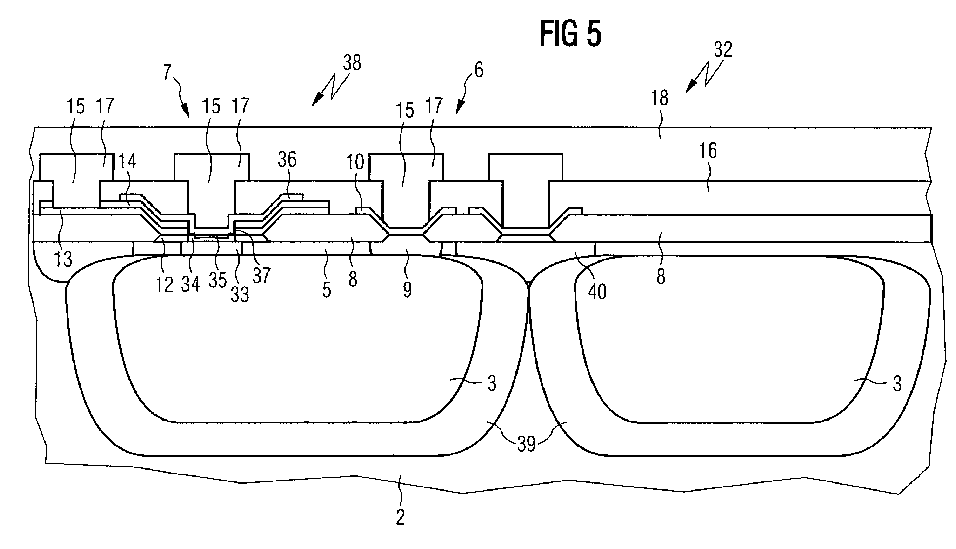

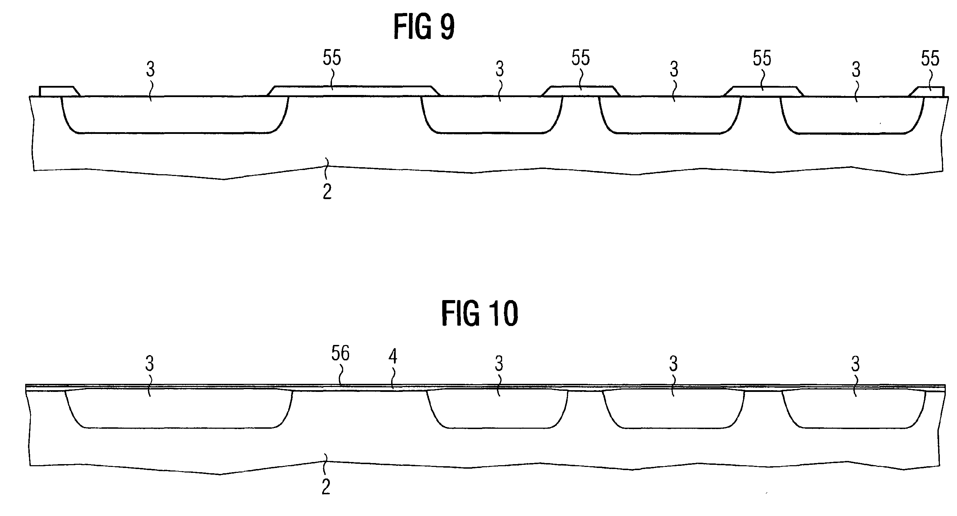

Nachfolgend wird die Herstellung der in den Figuren 1 bis 8 beschriebenen Bauelemente beispielhaft anhand der Figuren 9 bis 20 beschrieben.

Figur 9 zeigt im Querschnitt das Substrat 2. Dabei handelt es sich um p-leitendes Silizium mit einem spezifischen Widerstand von 1 kΩcm und einer Kristallorientierung in <100> - Richtung. Auf das Substrat 2 wird eine Oxidschicht 55 mit einer Dicke von 1 µm aufoxidiert. Anschließend wird die Oxidschicht 55 so strukturiert, daß sie an den für die Wannen 3 vorgesehenen Stellen Fenster aufweist. Gegebenenfalls kann die Oxidschicht 55 auch Fenster für die Trenngebiete 40 aufweisen. Durch die Implantation von Bor mit einer Konzentration von 2 x 1013 cm⁻² und einem nachfolgenden Diffusionsvorgang bei 1170°C während 500 Minuten werden gegebenenfalls die Grenzgebiete 39 des Substrats 2 ausgeformt. Danach folgt die Implantation von Arsen mit einer Konzentration von 2,2 x 1016 cm⁻² mit einer Ionenergie von 100 keV. In einem nachfolgenden Diffusionsvorgang bei 1170°C und einer Dauer von 1000 Minuten diffundiert das Arsen bis zu einer Tiefe von 10 µm in das Substrat 2 ein.

Das Ergebnis dieser Verfahrensschritte ist in Figur 9 dargestellt, wobei die Grenzgebiete 39 nicht dargestellt sind.

Durch Ätzen wird anschließend die Oxidschicht 55 entfernt und die Pufferschicht 4 bis zu einer Dicke von 0,3 µm aus undotiertem Material epitaktisch aufgewachsen. Dadurch ergibt sich der in Figur 10 dargestellte Querschnitt.

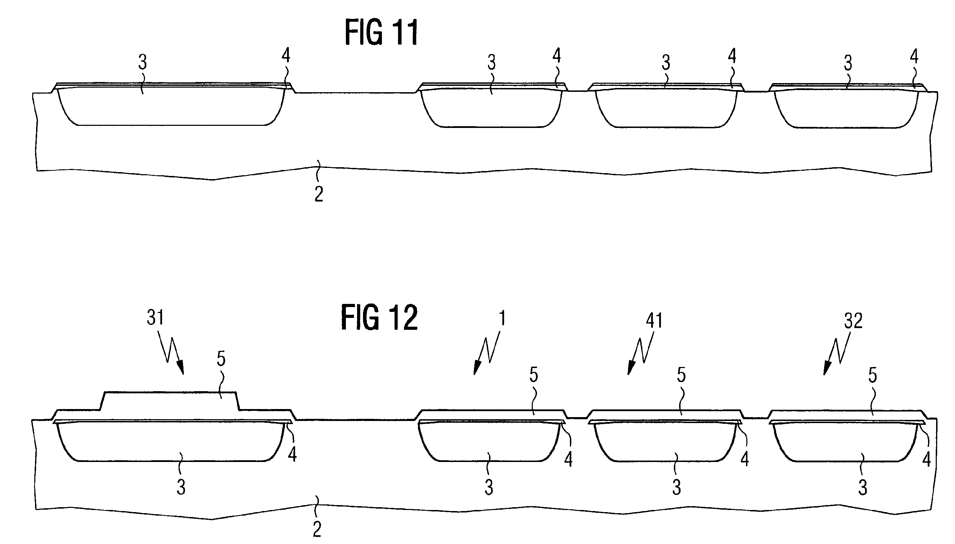

In weiteren Verfahrensschritten wird eine Fotolackschicht 56 auf die Pufferschicht 4 aufgebracht. Anschließend wird die Fotolackschicht 56 so strukturiert, daß in einem nachfolgenden Ätzprozeß die Pufferschicht 4 außerhalb des Bereichs der Wannen 3 entfernt wird. Zweckmäßigerweise wird die Pufferschicht 4 bis in das Substrat 2 hinein zurückgeätzt, was das vollständige Entfernen der Pufferschicht 4 sicherstellt, so daß sich der in Figur 11 Querschnitt ergibt.

Danach erfolgt das Aufwachsen der Epitaxieschicht 5 einschließlich dem Strukturieren der Epitaxieschicht 5, um beispielsweise im Bereich der PIN-Diode 31 eine Mesastruktur auszubilden. Daneben wird die Epitaxieschicht 5 auch im Bereich des Varaktors 1, des Kondensators 41 und des bipolaren Transistors 32, wie in Figur 12 dargestellt, zurückgeätzt.

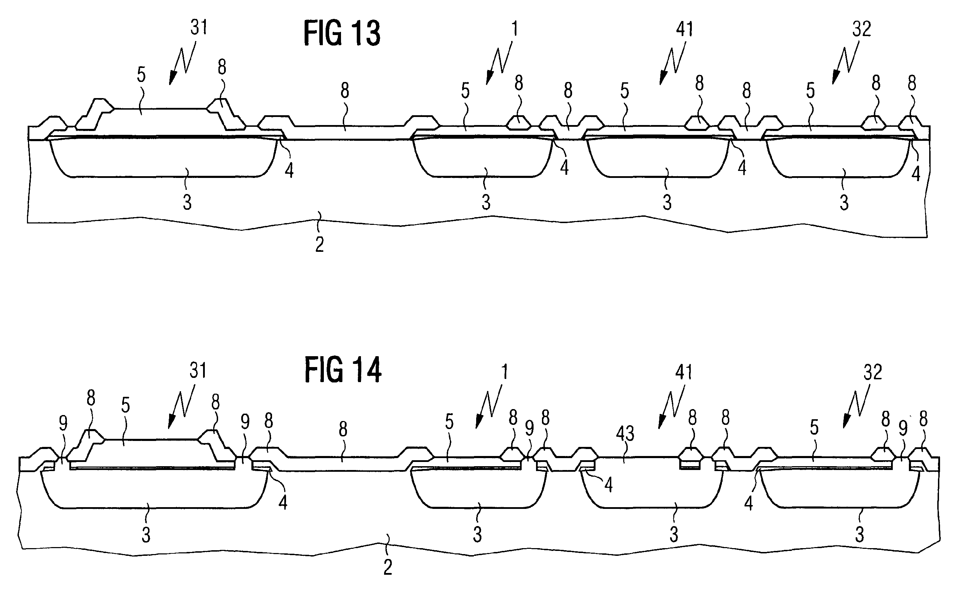

Daran schließt sich eine lokale Oxidation der Epitaxieschicht 5 an, die wie in Figur 13 dargestellt, zu einer bis zu 850 nm dicken Isolierschicht 8 führt.

Danach erfolgt die Implantation von Phosphor und dessen Tiefdiffusion zur Ausbildung der Kollektorkontaktbereiche 9 sowie insbesondere der Elektrodenimplantation 43 des Kondensators 41. Dadurch ergibt sich der Zustand gemäß Figur 14.

In weiteren Verfahrensschritten wird das Zwischendielektrikum 44 des Kondensators 41 und die Profilimplantation 11 des Varaktors 1 ausgebildet. Anschließend erfolgt das Abscheiden einer 200 nm dicken Polysiliziumschicht 57, in die im Bereich des Widerstands 46 Bor implantiert wird, um die Widerstandsschicht 47 im Bereich des Widerstands 46 auszubilden. Ansonsten wird die Polysiliziumschicht 57 schwach mit Bor dotiert, um so die Basisschicht 12 und im Bereich des Kondensators 41 die Kathode 45 bereitzustellen.

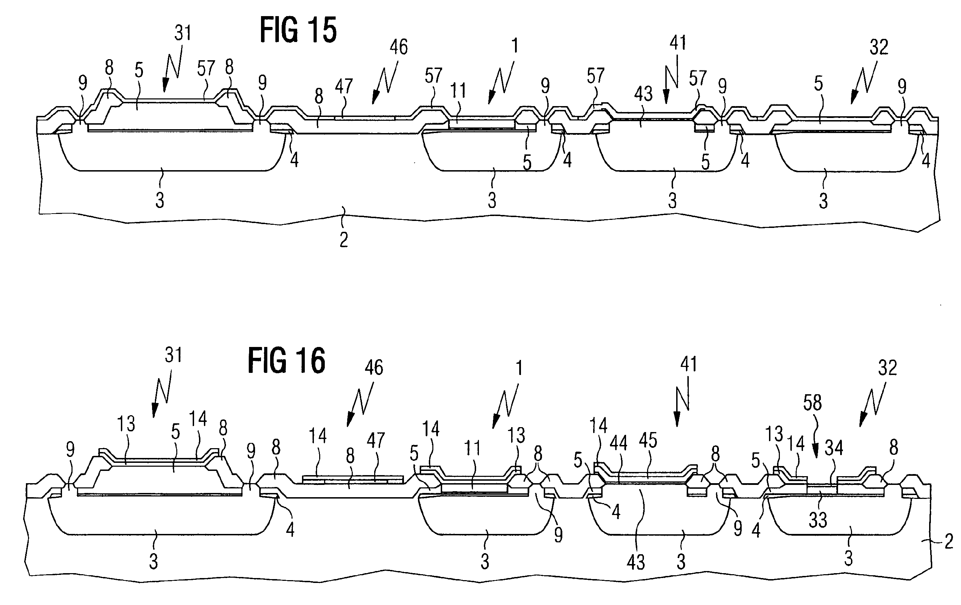

Gemäß Figur 16 wird daraufhin auf der Polysiliziumschicht 57 eine Oxidschicht mit einer Dicke von 300 nm abgeschieden, um die Kontaktisolierschicht 14 herzustellen. Die Polysiliziumschicht 57 wird mit der darüber liegenden Oxidschicht in einem Ätzvorgang strukturiert. Dabei wird im Bereich des bipolaren Transistors 38 ein Emitterkontaktloch 58 ausgeätzt, das sich wenigstens durch die Basisschicht 12 hindurch erstreckt. In dem verbleibenden Rest der Epitaxieschicht 5 wird die Kollektortiefimplantation 33 durch die Implantation von Phosphor ausgebildet. Daran schließt sich die Herstellung der Basiszone 34 durch die Implantation von Bor an. Nach Abschluß dieser Verfahrensschritte ergibt sich der in Figur 16 dargestellte Querschnitt.

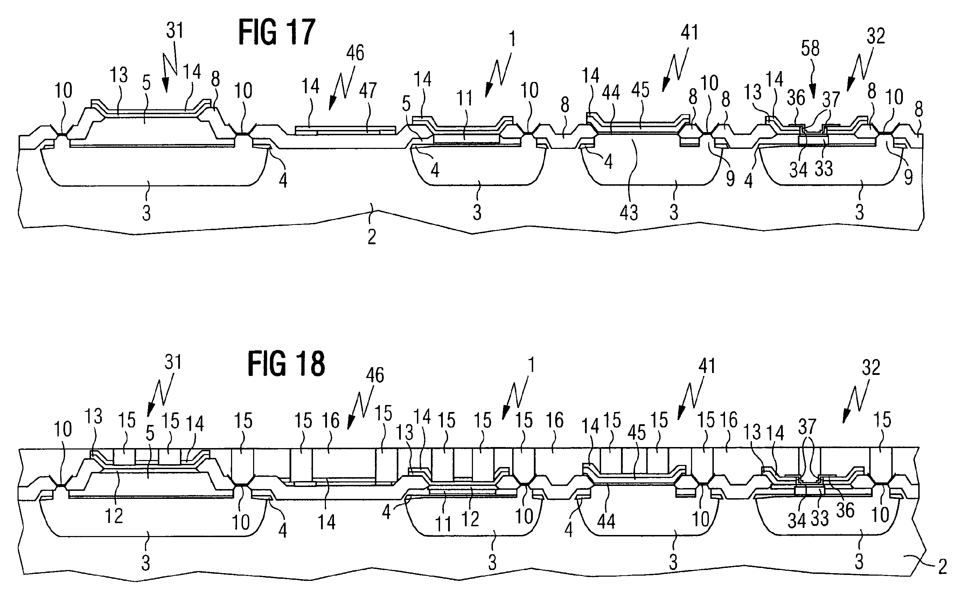

In Figur 17 ist das Verfahren bereits weiter fortgeschritten. Zunächst sind die Abstandstücke 37 im Emitterkontaktloch 58 ausgebildet worden. Dies erfolgt zweckmäßigerweise durch konformes Abscheiden und nachfolgendes anisotropes Ätzen. Außerdem sind die Kollektorkontaktschichten 10 und die Emitterkontaktschichten 36 durch Abscheiden von Polysilizium und nachfolgende Strukturieren ausgebildet worden.

Danach wird gemäß Figur 18 die Abdeckschicht 16 mit einer Dicke von bis zu 1200 nm aus Bor-haltigem Phosphorglas ganzflächig abgeschieden. Im darauf folgenden Verfließen bei 800°C diffundieren die Boratome aus den Basiskontaktschichten 13 in die darunterliegende Epitaxieschicht 5 und bilden die Basisschichten 12 aus. Im bipolaren Transistor 32 wird insbesondere die Emitterzone 35 durch Diffusion der Phosphoratome in der Emitterkontaktschicht 36 hergestellt.

Besonders von Vorteil ist, wenn das Verfließen bei zwei Temperaturhaltepunkte, einmal zwischen 750 und 850°C und zum anderen zwischen 1000 und 1100°C vorgenommen wird. Da die Temperaturempfindlichkeit der Parameter des bipolaren Transistors 38 bei niedrigen Temperaturen und die Parameter der PIN-Diode 31 und des Varaktors 1 bei hohen Temperaturen besonders groß sind, können durch das Verfließen bei unterschiedlichen Temperaturen die Dotierungsprofile im Varaktor 1 und im bipolaren Transistor 38 jeweils optimiert werden.

Anschließend werden in die Abdeckschicht 16 Löcher für die Anschlußkontakte 15 eingeätzt und mit Wolfram gefüllt, so daß sich schließlich der in Figur 18 gezeigte Querschnitt ergibt.

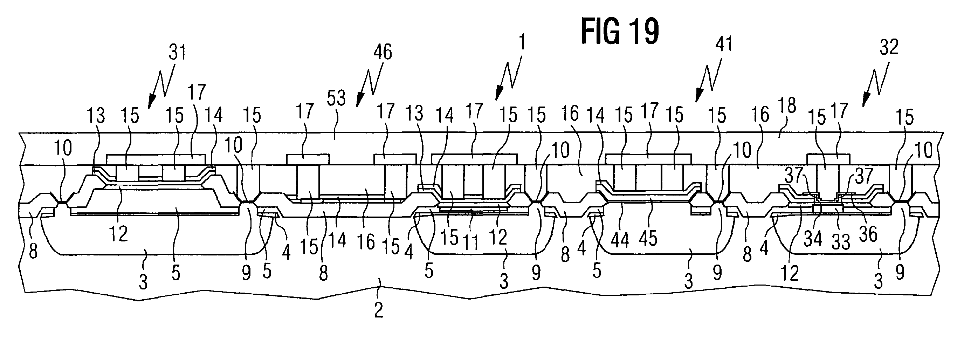

Gemäß Figur 19 wird daraufhin eine Schicht aus AlSiCu auf die Abdeckschicht 16 aufgesputtert und strukturiert, was die Leiterbahnen 17 ergibt. Auf die Leiterbahnen 17 wird ein 2 um dicke Oxidschicht als Zwischenlagendielektrikum 18 abgeschieden.

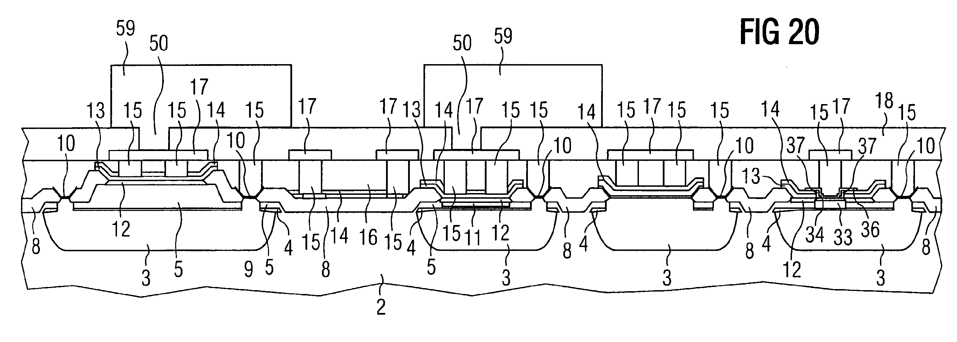

In dieses Zwischenlagendielektrikum 18 werden gemäß Figur 20 Kontaktlöcher für die Anschlußkontakte 50 eingeätzt. Daran schließt sich das Bedampfen mit TiAu an. Außerdem werden auf galvanischem Wege bis zu 7 µm an Au abgeschieden, um Leiterbahnen 59 der zweiten Metallebene 54 auszubilden. Gegebenenfalls werden dabei auch die Windungen 51 und 52 der Spule 48 hergestellt.

Abschließend ist festzuhalten, daß durch das anhand der Figur 9 bis 20 beschriebene Verfahren die Randverluste durch leitfähige, selbstdotierte Epitaxieschichten merklich verringert werden. Das Verfahren macht sich insbesondere den Umstand zunutze, daß die Dotieratome insbesondere beim Beginn des epitaktischen Wachstums aus den Wannen 3 ausdampfen und erneut in die epitaktische Schicht eingebaut werden. Mit zunehmender Schichtdicke der epitaktischen Schicht nimmt dieser Effekt jedoch rasch ab. Deshalb genügt es, die Pufferschicht im Bereich zwischen den Wannen 3 abzutragen, um die Ausbildung leitfähiger Schichten zwischen den Wannen 3 zu unterbinden und das Substrat 2 und die epitaktische Schicht 5 in diesem Gebiet hochohmig werden zu lassen. Da sich an der Oberfläche der Pufferschicht 4 nur wenige Dotieratome befinden, ist die Wanne 3 für nachfolgenden Epitaxieprozessen durch die Pufferschicht 4 gewissermaßen versiegelt. Dies führt dazu, daß die nachgeordnete Epitaxieschicht 5 kaum Dotieratome enthält und eine gute Isolationswirkung zeigt.

Es sei jedoch auch darauf hingewiesen, daß es möglich ist, zunächst auf das Substrat 2 eine Zwischenschicht epitaktisch aufzubringen, deren Dicke der Pufferschicht 4 und der Epitaxieschicht 5 entspricht, und anschließend die Zwischenschicht im Gebiet zwischen den Wannen 3 bis auf das Substrat 2 rückzuätzen, um so im Gebiet zwischen den Wannen 3 die besonders stark selbstdotierten Gebiete der Zwischenschicht entfernen. Diese Abwandlung des Verfahrens kommt insbesondere dann in Frage, wenn in den nachfolgenden Verfahrensschritten Stufen bis zu 1 µm in Kauf genommen werden können.

## Patentansprüche

1. Verfahren zur Herstellung einer Hochfrequenz-Halbleiterstruktur mit den Verfahrensschritten:
- Bereitstellen eines Substrats (2);
- Ausbilden einer dotierten Wanne (3), auf einer Seite des Substrats (2);
- epitaktisches Aufwachsen einer Pufferschicht (4) oberhalb der Wanne (3),
**dadurch gekennzeichnet,**
daß die die Wanne (3) abdeckende Pufferschicht (4) aus undotiertem Material hergestellt wird und
daß der das Substrat (2) abdeckende Teil der Pufferschicht (4) wenigstens teilweise abgetragen wird.

2. Verfahren nach Anspruch 1,
**dadurch gekennzeichnet,** da**ß**
der das Substrat (2) abdeckende Teil der Pufferschicht (4) vollständig entfernt wird.

3. Verfahren nach Anspruch 1 oder 2,
**dadurch gekennzeichnet, daß**
ein hochohmiges Substrat (2) mit einem spezifischen Widerstand größer 1 kΩcm verwendet wird.

4. Verfahren nach einem der Ansprüche 1 bis 3,
**dadurch gekennzeichnet, daß**
die Wanne (3) mit einer Konzentration von mehr als 6 x 1019 cm⁻³ dotiert wird.

5. Verfahren nach einem der Ansprüche 1 bis 4,
**dadurch gekennzeichnet, daß**
nach der Bearbeitung der Pufferschicht (4) Schichtfolgen zur Ausbildung bipolarer Transistoren (32, 38) und von Varaktoren (1) aufgebracht werden.

6. Verfahren nach Anspruch 5,
**dadurch gekennzeichnet, daß**
nach dem Aufbringen der Schichtfolgen eine kurzzeitige Temperung zwischen 750°C und 850°C und zwischen 1000°C und 1100°C durchgeführt wird.

7. Verfahren nach einem der Ansprüche 1 bis 6,
**dadurch gekennzeichnet, daß**
im Substrat (2) Wannen (3) ausgebildet werden, an deren Rand die Dotierung des Substrats angehoben wird.

8. Verfahren nach Anspruch 7,
**dadurch gekennzeichnet, daß**
die Bereiche mit erhöhter Substratdotierung an einen Massekontakt (40, 15) angeschlossen sind.

9. Halbleiterstruktur für Hochfrequenzen mit einer in einem Substrat (2) ausgebildeten dotierten Wanne (3), über die sich eine Pufferschicht (4) aus Substratmaterial befindet,
**dadurch gekennzeichnet,**
daß die Pufferschicht (4) die Wanne (3) abdeckt und aus einem undotierten Grundmaterial hergestellt ist und
daß der das Substrat (2) abdeckende Teil der Pufferschicht (4) wenigstens teilweise abgetragen ist.

10. Halbleiterstruktur nach Anspruch 9,
**dadurch gekennzeichnet, daß**
die Halbleiterstruktur einen bipolaren Transistor (32, 38) umfaßt, dessen Kollektor die im Substrat ausgebildete Wanne (3) umfaßt.

11. Halbleiterstruktur nach Anspruch 9 oder 10,
**dadurch gekennzeichnet, daß**
in der Halbleiterstruktur ein Varaktor (1) ausgebildet ist, dessen eine Elektrode (6) eine im Substratmaterial ausgebildete Wanne (3) umfaßt.

12. Halbleiterstruktur nach einem der Ansprüche 9 bis 11,
**dadurch gekennzeichnet, daß**
in der Halbleiterstruktur eine PIN-Diode (31) ausgebildet ist, deren eine Elektrode (6) eine im Substrat ausgebildete Wanne (3) umfaßt.

13. Halbleiterstruktur nach einem der Ansprüche 1 bis 12,
**dadurch gekennzeichnet, daß**
die Halbleiterstruktur einen Kondensator (41) aufweist, dessen eine Elektrode von einer im Substrat (2) ausgebildeten Wanne (3) gebildet ist.

14. Halbleiterstruktur nach einem der Ansprüche 1 bis 13,
**dadurch gekennzeichnet, daß**
in der Halbleiterstruktur ein aus Halbleitermaterial hergestellter Widerstand (46) ausgebildet ist.

15. Halbleiterstruktur nach einem der Ansprüche 1 bis 14,
**dadurch gekennzeichnet, daß**
die Halbleiterstruktur eine von Leiterbahnen gebildete Spule 48 umfaßt.
